(19) Europäisches Patentamt

European Patent Office

Office européen des brevets

(11) Veröffentlichungsnummer: 0 196 534
A1

(12) EUROPÄISCHE PATENTANMELDUNG

(21) Anmeldenummer: 86103572.3

(22) Anmeldetag: 17.03.86

(51) Int. Cl.4: G01R 31/28

(30) Priorität: 22.03.85 DE 3510525

(43) Veröffentlichungstag der Anmeldung:
08.10.86 Patentblatt 86/41

(84) Benannte Vertragsstaaten:
DE FR GB IT NL

(71) Anmelder: Siemens Aktiengesellschaft Berlin und
München
Wittelsbacherplatz 2
D-8000 München 2(DE)

(72) Erfinder: Brust, Hans-Detlef
Martin-Luther-Strasse 2
D-6602 Dudweiler(DE)
Erfinder: Otto, Johann, Dipl.-Ing.
Pater-Hammerschmid-Strasse 4
D-8170 Bad Tölz(DE)

(54) Verfahren zur Ermittlung der Signalfrequenzen an wenigstens einem Punkt einer Probe mittels eines Rastermikroskops und Anordnung zur Durchführung des Verfahrens.

(57) Zur Ermittlung der an wenigstens einem Punkt der Probe (IC) vorhandenen Signalfrequenzen wird dieser mit einem Primärstrahl des Rastermikroskops abgetastet. Über eine breitbandige Auswerteschaltung (LI') wird bei einer relativ - schnellen Durchstimmung des Frequenzbereichs zunächst ermittelt, wann die Auswerteschaltung (LI') gerade auf eine Signalfrequenz abgestimmt ist. Liegt eine solche Abstimmung vor, so erfolgt eine Umschaltung auf eine schmalbandige Auswerteschaltung (LI) sowie eine Umschaltung auf eine langsame Durchstimmung. Damit wird eine hohe Empfindlichkeit bei insgesamt kurzer Meßzeit erreicht.

FIG 1

EP 0 196 534 A1

Verfahren zur Ermittlung der Signalfrequenzen an wenigstens einem Punkt einer Probe mittels eines Rastermikroskops und Anordnung zur Durchführung des Verfahrens

Die Erfindung bezieht sich auf ein Verfahren zur Ermittlung der Signalfrequenzen an wenigstens einem Punkt der Probe mittels eines Rastermikroskops nach den gleichlautenden Oberbegriffen der Patentansprüche 1 und 3 sowie auf Schaltungsanordnungen zur Durchführung des Verfahrens.

Ein Verfahren dieser Art ist bereits in der deutschen Patentanmeldung P 34 20 269.0 vorgeschlagen worden. Dabei tastet der Korpuskularstrahl eines Rastermikroskops wenigstens einen Punkt einer Probe ab. Die erste Auswerteschaltung besteht aus einem "Lock-in"-Verstärker, der mittels eines Wobbelgenerators durch den interessierenden Signalfrequenzbereich durchgestimmt wird. Die Signalanteile eines von dem jeweils abgetasteten Punkt über einen Detektor abgeleiteten sekundären elektrischen Signals werden, soweit sie in dem Signalfrequenzbereich liegen, durch den Lock-in-Verstärker selektiert und demoduliert. Das Ausgangssignal des Lock-in-Verstärkers wird dann zur Feststellung der einzelnen Signalfrequenzen herangezogen.

Ein weiteres Verfahren dieser Art ist in der deutschen Patentanmeldung P 34 20 272.2 vorgeschlagen worden. Hier wird zum Unterschied von dem vorstehend beschriebenen Verfahren der Korpuskularstrahl des Rastermikroskops mittels eines Wobbelgenerators und eines von diesem gesteuerten Austastgenerators mit einer einstellbaren Pulsfrequenz gepulst. Die erste Auswerteschaltung besteht hier aus einem Bandfilter mit einer festen Mittenfrequenz und mit einem schmalen Durchlaßbereich.

Bei den vorstehend erwähnten Verfahren ist die maximale Wobbelgeschwindigkeit der Wobbelgeneratoren und damit die maximale Änderungsgeschwindigkeit beim Durchstimmen durch den Frequenzbereich durch die Bandbreite der ersten Auswerteschaltung begrenzt. Für eine schnelle Messung, die auch im Hinblick auf eine möglichst geringe Belastung der Probe durch den Elektronenstrahl wünschenswert ist, muß diese Bandbreite möglichst groß sein. Eine Verringerung der Bandbreite unter einen bestimmten Wert führt bei sonst gleichen Verhältnissen dazu, daß mit dem Verfahren keine korrekten Ergebnisse mehr erzielt werden können.

Der Erfindung liegt die Aufgabe zugrunde, eine Verringerung der für die Abtastung der Probenoberfläche oder eines Teiles derselben benötigten Meßzeit zu erzielen, ohne die bei den vorgeschlagenen Verfahren hierzu erforderliche Vergrößerung der Bandbreite der Auswerteschaltung, die eine Verschlechterung des Signal-Rausch-Verhältnisses am Ausgang derselben mit sich bringt, in Kauf zu nehmen. Das wird erfindungsgemäß durch eine Ausbildung des eingangs genannten Verfahrens nach dem kennzeichnenden Teil des Patentanspruchs 1 erreicht. Gemäß weiterer Erfindung wird die Aufgabe auch bei einer Ausbildung des eingangs genannten Verfahrens nach dem kennzeichnenden Teil des Anspruchs 3 gelöst.

Der mit der Erfindung erzielbare Vorteil liegt insbesondere darin, daß die Durchstimmung der Auswerteschaltung durch diejenigen Teile des Frequenzbereichs, in denen die gesuchten Signalfrequenzen tatsächlich liegen, hinreichend langsam erfolgt, um diese Signalfrequenzen genau zu erfassen. Die übrigen Teile des Frequenzbereichs, in denen keine Signalfrequenzen angetroffen werden, können dagegen schnell überstrichen werden. Daher verringert sich die Meßzeit erheblich, ohne daß die Empfindlichkeit des Verfahrens beeinträchtigt wird.

Die Erfindung wird nachfolgend anhand der Zeichnung näher erläutert. Dabei zeigen:

Fig. 1 eine erste Anordnung zur Durchführung des erfindungsgemäßen Verfahrens,

Fig. 2 eine zweite Anordnung zur Durchführung des erfindungsgemäßen Verfahrens und

Fig. 3 eine Teilschaltung der Anordnungen nach Fig. 1 und Fig. 2.

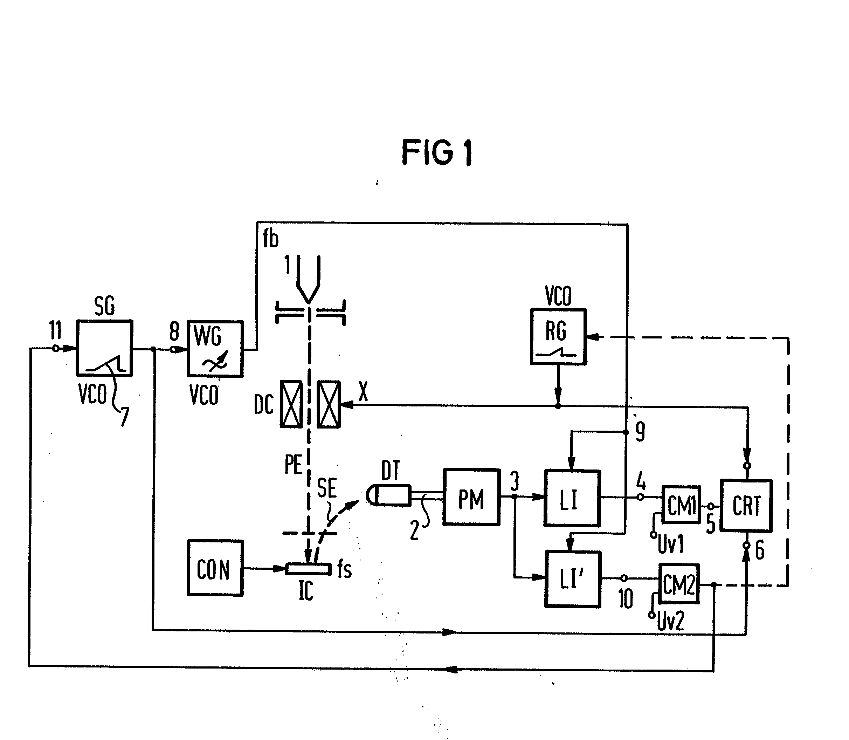

Bei der Anordnung nach Fig. 1 bilden die aus einer Elektronenquelle 1 eines Rasterelektronenmikroskops austretenden Elektronen eine Primärstrahl PE. Dieser trifft auf einen Punkt einer Probe IC, z.B. eines zu untersuchenden integrierten Schaltkreises, und löst dort Sekundärelektronen aus. Diese werden in einem Detektor DT nachgewiesen. In Abhängigkeit von dem Sekundärelektronenstrom, der auf den Detektor DT auftrifft, wird in diesem ein Sekundärelektronensignal erzeugt, das einem Fotomultiplier PM über einen Lichtleiter 2 zur Abgabe eines sekundären elektrischen Signals zugeführt wird. Das sekundäre elektrische Signal wird nach einer Verstärkung in einem Vorverstärker PM dem Eingang 3 einer ersten Auswerteschaltung LI zugeführt, die als schmalbandiger "Lock-in"-Verstärker ausgebildet ist. Das bei 4 auftretende Ausgangssignal von LI gelangt zu einem Komparator CM1, der mit einer insbesondere einstellbaren Vergleichsspannung Uv1 beaufschlagt ist. Übersteigt das Ausgangssignal von LI den Wert von Uv1, so wird es vom Ausgang des Komparators CM1 an den Intensitätssteuereingang 5 einer Bildröhre CRT gelegt. Der Elektronenstrahl der Bildröhre wird durch eine y-Ablenkeinrichtung positioniert, über einen Eingang 6 von der Ausgangsspannung eines Generators SG beeinflußt wird. SG liefert ein insbesondere periodisches Rampen-oder Treppensignal 7, das auch an den Frequenzsteuereingang eines ersten Wobbelgenerators WG gelegt ist und diesen innerhalb eines interessierenden Frequenzbereiches durchwobbelt. Da die Ausgangsspannung des Wobbelgenerators WG mit der Frequenz fb dem Lock-in-Verstärker über einen Eingang 9 als Referenzspannung zugeführt wird, wird LI über den Frequenzbereich periodisch durchgestimmt.

Die integrierte Schaltung IC wird von einer Ansteuerung CON aus mit wenigstens einem Signal belegt. Unter der Annahme, daß der durch PE abgetastete Punkt der Probe ein Signal mit der zunächst unbekannten Signalfrequenz fs führt, enthält auch das am Eingang 3 anliegende sekundäre elektrische Signal einen Signalanteil mit der zunächst unbekannten Frequenz fs. Aus dem sekundären elektrischen Signal kann in LI dieser Signalanteil mit der Frequenz fs genau dann ausgefiltert werden, wenn über den Eingang 9 ein Referenzsignal zugeführt wird, dessen Frequenz fb mit fs übereinstimmt. In diesem Fall entsteht ein Ausgangssignal am Ausgang 4 von LI, das die Intensität des Elektronenstrahls der Bildröhre CRT steuert. Gleichzeitig bewirkt das Ausgangssignal des Generators SG, das dem Wert der Frequenz fb von WG entspricht, eine Ablenkung des Elektronenstrahls in y-Richtung, so daß auf dem Bildschirm von CRT die jeweilige Signalfrequenz als heller Punkt auf einer vertikalen Geraden dargestellt wird. Selbstverständlich können die Signale auch einem Rechner als Aufzeichnungsmedium zugeführt werden.

Nach einer bevorzugten Weiterbildung der Anordnung nach Fig. 1 wird die Ablenkeinrichtung DC des Rastermikroskops über einen Rastergenerator RG in x-Ablenkrichtung angesteuert. Hierbei kann die Information darüber, welcher Punkt einer auf einer horizontalen Geraden liegenden Gruppe von Punkten auf der Probe gerade durch PE abgetastet wird, auch durch eine entsprechende Ablenkung des Elektronenstrahls von CRT in x-Richtung dargestellt werden. Wenn nun der durch RG abgelenkte Primärstrahl PE ständig entlang einer Linie (line scan) in x-Richtung oder zwischen einzelnen Punkten hin und her (vector scan) abgelenkt wird, während zugleich die Frequenz fb des am Eingang 9 anliegenden Referenzsignals den in Frage kommenden Frequenzbereich überstreicht und eine fb proportionale Spannung gleichzeitig den Elektronenstrahl von CRT in y-Richtung ablenkt, so entsteht auf dem Bildschirm folgende Darstellung: Immer dann, wenn die Frequenz fb den Wert einer Signalfrequenz fs erreicht, die in dem jeweils abgetasteten Punkt vorhanden ist, erscheint ein Punkt bzw. Strich, dessen Länge durch die Anzahl der abgetasteten Punkte bestimmt ist, die diese Signalfrequenz führen.

In Fig. 1 ist eine zweite Auswerteschaltung LI' vorgesehen, die entsprechend der Auswerteschaltung LI, aber wesentlich breitbandiger ausgebildet ist als diese. LI' liegt mit ihrem Eingang am Schaltungspunkt 3 und ist somit der Auswerteschaltung LI eingangsseitig parallel geschaltet. Das .bezieht .sich auch auf den Referenzsignaleingang von LI', der mit dem Schaltungspunkt 9 verbunden ist. Das am Ausgang 10 von LI' auftretende Ausgangssignal gelangt zu einem Komparator CM2, der mit einer insbesondere einstellbaren Vergleichsspannung Uv2 beaufschlagt ist. Übersteigt das Ausgangssignal von LI' den Wert von Uv2, so gelangt es an den .Steuereingang 11 des Generators SG.

Nach dem erfindungsgemäßen Verfahren wird die erste Auswerteschaltung LI mittels des ersten Wobbelgenerators WG durch den interessierenden Frequenzbereich durchgestimmt, wobei ihrem Steuereingang 9 das in seiner Frequenz fb entsprechend variierte Referenzsignal zugeführt wird. Führt nun der durch PE abgetasete Punkt der Probe ein Signal mit einer Signalfrequenz, die der jeweiligen Frequenz fb entspricht, so entsteht am Ausgang 10 der breitbandigen Auswerteschaltung LI' ein Ausgangssignal, das beim Überschreiten eines durch Uv2 gegebenen Schwellwertes zum Steuereingang 11 des Signalgenerators SG gelangt und diesen dazu verlanlaßt, ein Rampen-oder Treppensignal 7 mit einer kleineren Flankensteilheit abzugeben. Damit wird jedoch am Ausgang 4 von LI ein Ausgangssignal erhalten, das bei einer niedrigeren Wobbelgeschwindigkeit von WG gewonnen wird. Dieses Ausgangssignal wird im dargestellten Beispiel zur Helligkeitsmodulation der Bildröhre CRT verwendet, so daß der die aufgefundene Signalfrequenz fs darstellende Strich auf dem Bildschirm von CRT durch seine Helligkeit hervorgehoben wird. Die zweite Auswerteschaltung LI' dient nur dazu festzustellen, wann eine Signalfrequenz fs mit der jeweiligen Frequenz fb übereinstimmt und beim Eintreten einer solchen Übereinstimmung die Umschaltung von WG auf die niedrigere Wobbelgeschwindigkeit zu veranlassen. Hierdurch kann die normale Wobbelgeschwindigkeit so hoch gestellt werden, daß die nicht interessierenden Teile des Frequenzbereichs, in denen keine Signalfrequenzen liegen, schnell durchlaufen werden. Die höhere Wobbelgeschwindigkeit, die eine genaue Ermittlung der Signalfrequenzen überhaupt nicht gestatten würde, wird beim Erreichen der interessierenden Teile des Frequenzbereichs durch eine langsame, für die genaue Ermittlung der Signalfrequenzen notwendige Wobbelgeschwindigkeit ersetzt. Nach dem Verlassen des

interessierenden Teil des Frequenzbereichs ist dann auch das Ausgangssignal LI' wieder verschwunden, so daß der Wobbelgenerator WG auf die größere Wobbelgeschwindigkeit rückgeschaltet wird.

Nach einer anderen Ausgestaltung der Anordnung nach Fig. 1 kann die erste Auswerteschaltung LI in ihrer Bandbreite veränderbar sein. Hierbei arbeitet sie zunächst in einem breitbandigen Betriebsmodus, wobei der Wobbelgenerator WG auf seine größere Wobbelgeschwindigkeit eingestellt ist. Während des Auftretens eines Ausgangssignals am Ausgang 4 bzw. 5 wird dann von dort ein Eingang von LI angesteuert, über den eine Umschaltung der Auswerteschaltung in ihren schmalbandigen Betriebsmodus vorgenommen wird. Gleichzeitig ist dann auch der Ausgang 4 bzw. 5 mit dem Eingang 11 von SG verbunden, so daß WG durch das Ausgangssignal an 4 bzw. 5 auf die niedrigere Wobbelgeschwindigkeit umgeschaltet wird. Die weitere Auswertung des Ausgangssignals von LI erfolgt in der bereits beschriebenen Weise.

Die "Lock-in"-Verstärkung LI und LI' sind als solche bekannt und können z.B. aus Ithaco-Verstärkern des Typs 391A bestehen. LI kann z.B. eine Bandbreite von 100 Hz aufweisen, LI' eine solche von 1 kHz. Das Rasterelektronenmikroskop kann z.B. aus dem ETEC-Autoscan II bestehen. Ein Gerät dieser Art ist beispielsweise aus der US-Patentschrift 4 277 679 bekannt.

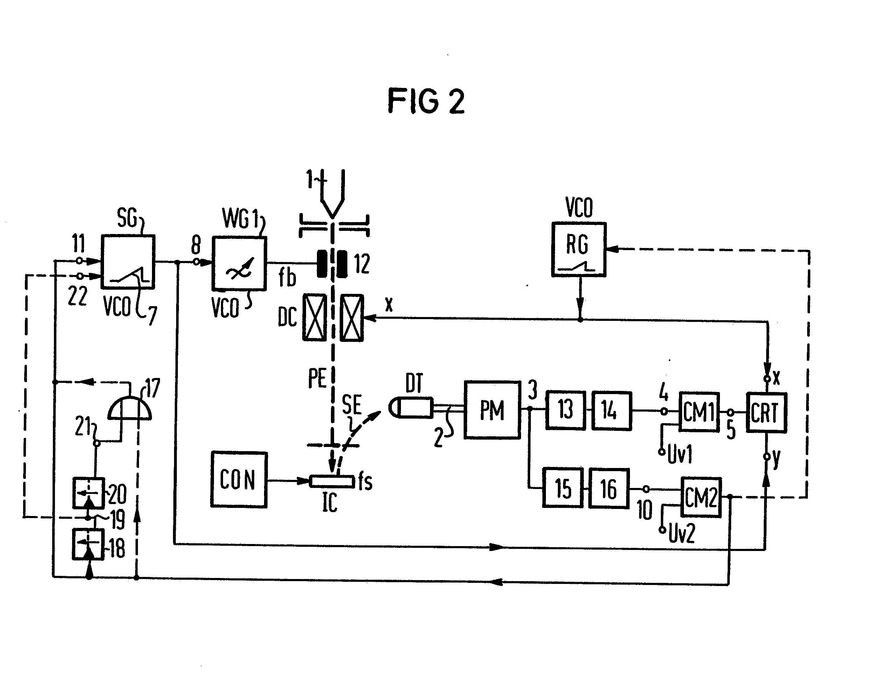

Fig. 2 zeigt eine weitere Anordnung, die zur Durchführung des erfindungsgemäßen Verfahrens geeignet ist. Hier kann ein Rasterelektronenmikroskop verwendet werden, wie es z.B. aus der US-Patentschrift 4 223 220 bekannt ist. Die bereits anhand von Fig. 1 beschriebenen Schaltungsteile sind in Fig. 2 mit denselben Bezugszeichen versehen. Im Unterschied zu Fig. 1 wird der Primärstrahl PE mittels eines Modulationssystems 12 in seiner Intensität moduliert. Ein solches System ist z.B. aus der US-Patentschrift 4 169 229 bekannt. Es wird von einem zweiten Wobbelgenerator WG1 mit einer Modulationsfrequenz fb angesteuert, die gegenüber der gesuchten Signalfrequenz um einen festen Frequenzbetrag df versetzt ist. Ein an dem abgetasteten Punkt der Probe angetroffenes Signal der Signalfrequenz fs bzw. einer Oberschwingung von fs mischt sich mit der Frequenz fb bzw. einer Oberschwingung von fb, mit der PE intensitätsmoduliert ist, zu einem Zwischenfrequenzsignal der Festfrequenz df. Damit weist das sekundäre elektrische Signal, das am Schaltungspunkt 3 anliegt, einen Signalanteil der Festfrequenz df auf. Die erste Auswerteschaltung besteht hier aus einem schmalbandigen Bandpaß und einem diesem nachgeschalteten Amplitudendemodulator 14. Die zweite Auswerteschaltung wird aus einem breitbandigen Bandpaß 15 und einem diesem nachgeschalteten Amplitudendemodulator 16 gebildet. Beide Bandpässe 13 und 15 sind auf die feste Frequenz df abgestimmt. Der von dem Bandpaß 13 übertragende Signalanteil wird in 14 demoduliert, wobei jedes Uv1 übersteigende Signal eine Helligkeitsmodulation des jeweiligen Bildpunktes auf der Bildröhre CRT bewirkt. Das sekundäre elektrische Signal wird andererseits über den breitbandigen Bandpaß 15 selektiert, in 16 demoduliert und ergibt somit ein Ausgangssignal am Ausgang 10, das beim Überschreiten einer Spannungsquelle Uv2 dem Steuereingang von SG zugeführt wird und zur Umschaltung des zweiten Wobbelgenerators WG1 von einer normalen, höheren Wobbelgeschwindigkeit auf eine niedrigere Wobbelgeschwindigkeit dient.

In Fig. 2 ist nach einer bevorzugten Weiterbildung der Anordnung gestrichelt angedeutet, daß der Ausgang 10 der zweiten Auswerteschaltung auch mit dem ersten Eingang eines ODER-Gatters 17 verbunden sein kann, dessen Ausgang dann an den Steuereingang 11 von SG geführt ist. In diesem Fall ist der Ausgang 10 auch mit dem Takteingang eines Monoflops 18 beschaltet, dessen Ausgang 19 mit dem Takteingang eines zweiten Monoflops 20 verbunden ist. Dessen Ausgang 21 liegt an einem zweiten Eingang des ODER-Gatters 17. Der Ausgang 19 ist schließlich mit einem zweiten Steuereingang 22 von SG verbunden, über den die Änderungsrichtung des Rampen-oder Treppensignals 7 umgekehrt werden kann. Eine positiv gehende Anstiegsflanke wird dabei in eine negativ gehende Flanke umgeschaltet. Sobald ein Ausgangssignal der breitbandigen Auswerteschaltung 15, 16 erhalten wird, kippt das Monoflop 18 um und liefert über 19 ein Signal, das am Eingang 22 eine Umkehrung der Änderungsrichtung des Rampen-oder Treppensignals 7 und damit eine Umkehr der Änderungsrichtung der gewobbelten Frequenz fb bewirkt. Weiterhin wird auch die Laufrichtung des Elektronenstrahls der Bildröhre CRT umgekehrt. Die Länge des von 18 abgegebenen Signals bestimmt dabei das Ausmaß des sich für die Wobbelfrequenz fb und den Elektronenstrahl von CRT ergebenden Rücksprungs. Dieser Rücksprung wird zweckmäßigerweise mit der hohen Wobbelgeschwindigkeit vorgenommen. Nach Beendigung des Rücksprungs wird die Wobbelfrequenz fb wieder in der ursprünglichen Richtung variiert und der Elektronenstrahl von CRT wieder in Vorwärtsrichtung abgelenkt, wobei das durch die Rückflanke des von 19 abgegebenen Signals gekippte Monoflop 20 innerhalb seiner Eigenzeit über 21 ein Signal abgibt, das dem Steuereingang 11 mitgeteilt wird und eine langsame Wobbelgeschwindigkeit bewirkt, auch wenn durch den Rücksprung am Ausgang 10 kein Ausgangssignal mehr vorhanden ist. Durch diese Weiterbildung wird vermieden, daß der Wobbelgenerator WG1 infolge seiner hohen Wobbelgeschwindigkeit beim Erreichen der Grenzen der interessierenden Teilbereiche des Frequenzbereichs die unmittelbar zu diesen Teilbereichsgrenzen gehörenden Signalfrequenzen nur ungenau auszuwerten gestattet.

Auch bei der Anordnung nach Fig. 2 kann die zweite Auswerteschaltung 15, 16 entfallen, wenn dafür die erste Auswerteschaltung 13, 14 einen Bandpaß 13 mit veränderbarer Bandbreite aufweist. In diesem Fall arbeitet die Auswerteschaltung 13, 14 zunächst in einem breitbandigen Betriebsmodus, wobei WG1 auf eine hohe Wobbelgeschwindigkeit eingestellt ist. Während des Auftretens eines Ausgangssignals am Ausgang 4 bzw. 5 wird dann ein Steuereingang des Bandpasses 13 mit diesem Signal belegt, wodurch eine Umschaltung von 13 in den schmalbandigen Betriebsmodus erfolgt. Gleichzeitig wird auch der Steuereingang 11 von SG mit diesem Signal beaufschlagt, so daß WG1 auf die niedrige Wobbelgeschwindigkeit umgeschaltet wird.

Nach einer bevorzugten Ausgestaltung des Verfahrens nach der Erfindung können die während einer ersten - schnellen Durchstimmsequenz durch den Frequenzbereich erhaltenen Ausgangssignale der zweiten Auswerteschaltung LI' bzw. 15, 16 auch zwischengespeichert werden, z.B. in dem Speicher eines Rechners, wobei dann mit Hilfe der ersten schmalbandigen Auswerteschaltung LI bzw. 13, 14 in einer zweiten langsamen Durchstimmsequenz in den Teilbereichen, in denen bei der schnellen Durchstimmsequenz ausgangsseitige Signale erhalten wurden, eine genaue Auswertung mittels der Ausgangssignale der ersten Auswerteschaltung vorgenommen wird.

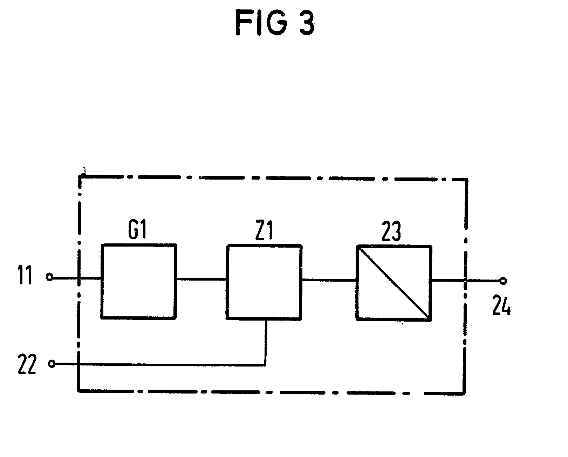

Fig. 3 zeigt eine zweckmäßige schaltungstechnische Durchbildung des Signalgenerators SG. Danach besteht dieser aus einem Taktoszillator G1, der durch ein am Eingang 11 liegendes Signal in seiner Taktfrequenz beeinflußt wird. Man kann G1 auch als einen VCO (Voltage Controlled Oscillator) bezeichnen. Ein nachgeschalteter Zähler Z1 zählt die von G1 abgegebenen Taktimpulse, wobei über einen Digital-Analog-Wandler 23 ein dem jeweiligen Zählerinhalt amplitudenmäßig entsprechendes analoges Signal abgeleitet wird. Dieses stellt dann bei periodischer Rücksetzung von Z1 auf einen Anfangswert das Rampen-oder Treppensignal 7 dar, das über den Ausgang 24 dem Frequenzsteuereingang von WG1 zugeführt wird. Zur Umkehrung der Änderungsrichtung des Rampen-oder Treppensignals 7 wird dem Eingang 22 ein Signal zugeführt, das die Zählrichtung von Z1 umkehrt.

Nach einer bevorzugten Weiterbildung der Anordnung gemäß den Figuren 1 oder 2 wird das am Schaltungspunkt 10 auftretende Ausgangssignal der zweiten Auswerteschaltung LI' bzw. 15, 16 einem Steuereingang des Rastergenerators RG zum Zwecke der Reduzierung der Abtastgeschwindigkeit zugeführt.

Im Rahmen der Erfindung können zum Abtasten der Probe IC in Abweichung von den in den Figuren dargestellten Anordnungen auch andere Rastermikroskope verwendet werden, so z.B. ein Laserscanner oder ein SAM (Scanning Acoustic Microscope).

Die Umschaltung der Wobbelgeschwindigkeit und der Bandbreite bei den Anordnungen mit nur einer Auswerteschaltung kann sowohl in diskreten Schritten als auch kontinuierlich erfolgen.

Die Ansteuerung CON ist bei den Anordnungen nach den Figuren 1 und 2 nicht unbedingt erforderlich, sofern die Probe IC auch ohne Ansteuerung arbeiten kann. Eine Synchronisation des Referenzsignals (fb) und des Signals auf der Probe IC ist ebenfalls nicht unbedingt erforderlich.

Eine vorteilhafte Weiterbildung der Anordnungen nach den Figuren 1 oder 2 besteht darin, daß das Ausgangssignal der zweiten Auswerteschltung LI' bzw. 15, 16 einem Steuereingang des Rastergenerators RG zum Zwecke einer Reduzierung der Rastergeschwindigkeit zugeführt wird. Für den Fall, daß eine in ihrer Bandbreite umschaltbare erste Auswerteschltung LI bzw. 13, 14 verwendet wird, wird diese Ansteuerung des Rastergenerators RG vom Ausgang der ersten Auswerteschaltung aus vorgenommen.

## Ansprüche

1. Verfahren zur Ermittlung der Signalfrequenzen an wenigstens einem Punkt einer Probe mittels eines Rastermikroskops, bei dem der Punkt von einem Primärstrahl abgetastet wird, bei dem von dem jeweils abgetasteten Punkt sekundäre elektrische Signale, insbesondere über einen Detektor, abgeleitet und einer ersten Auswerteschaltung zugeführt werden, die die Signalanteile, welche in einem Signalfrequenzbereich enthaltene Signalfrequenzen aufweisen, selektiert und demoduliert oder gleichrichtet, und bei dem das Ausgangssignal der ersten Auswerteschaltung zur Feststellung der einzelnen Signalfrequenzen herangezogen wird, wobei die Auswerteschaltung entweder mittels eines ersten Wobbelgenerators über den Signalfrequenzbereich durchgestimmt wird oder bei einer Intensitätsmodulation des Primärstrahls mittels eines zweiten, über einen dem Signalfrequenzbereich entsprechenden Bereich durchstimmbaren Wobbelgenerators und einer von diesem gesteuerten Modulationseinrichtung auf eine feste Frequenz abgestimmt ist, **dadurch gekennzeichnet,** daß die erste Auswerteschaltung (LI) schmalbandig ausgebildet und daß eine entsprechend der ersten, jedoch wesentlich breitbandiger ausgebildete, zweite Auswerteschaltung (LI') verwendet wird, deren Ausgangssignal zur Umschaltung des ersten oder zweiten Wobbelgenerators (WG) auf eine niedrigere

Wobbelgeschwindigkeit herangezogen wird.

2. Verfahren nach Anspruch 1, **dadurch gekennzeichnet,** daß das Ausgangssignal der zweiten Auswerteschaltung - (LI') während einer ersten Durchstimmungssequenz des ersten oder zweiten Wobbelgenerators (WG) zunächst zwischengespeichert wird und sodann während einer zweiten Durchstimmungssequenz zur Umschaltung des ersten oder zweiten Wobbelgenerators (WG) auf die niedrigere Wobbelgeschwindigkeit herangezogen wird.

3. Verfahren zur Ermittlung der Signalfrequenzen an wenigstens einem Punkt einer Probe mittels eines Rastermikroskops, bei dem der Punkt von einem Primärstrahl abgetastet wird, bei dem von dem jeweils abgetasteten Punkt sekundäre elektrische Signale, insbesondere über einen Detektor, abgeleitet und einer ersten Auswerteschaltung zugeführt werden, die die Signalanteile, welche in einem Signalfrequenzbereich enthaltene Signalfrequenzen aufweisen, selektiert und demoduliert oder gleichrichtet, und bei dem das Ausgangssignal der ersten Auswerteschaltung zur Feststellung der einzelnen Signalfrequenzen herangezogen wird, wobei die Auswerteschaltung entweder mittels eines ersten Wobbelgenerators über den Signalfrequenzbereich durchgestimmt wird oder bei einer Intensitätsmodulation des Primärstrahls mittels eines zweiten, über einen dem Signalfrequenzbereich entsprechenden Bereich durchstimmbaren Wobbelgenerators und einer von diesem gesteuerten Modulationseinrichtung auf eine feste Frequenz abgestimmt ist, **dadurch gekennzeichnet,** daß die erste Auswerteschaltung (LI) in ihrer Bandbreite veränderbar ist, daß diese zunächst in einem breitbandigen Betriebsmodus arbeitet, und daß während der Dauer des Auftretens eines Ausgangssignals der ersten Auswerteschaltung (LI) eine Umschaltung derselben für die Dauer dieses Auftretens in einen schmalbandigen Betriebsmodus vorgenommen wird, wobei der erste oder zweite Wobbelgenerator (WG) für die Dauer dieser Umschaltung auf eine niedrigere Wobbelgeschwindigkeit umgeschaltet wird.

4. Verfahren nach Anspruch 3, **dadurch abgewandelt,** daß die Umschaltung der ersten Auswerteschaltung (LI) in einen schmalbandigen Betriebsmodus nicht während des Auftretens eines Ausgangssignals der letzteren vorgenommen wird, sondern daß während einer ersten Durchstimmsequenz des ersten oder zweiten Wobbelgenerators das Ausgangssignal der ersten Auswerteschaltung (LI) zunächst zwischengespeichert wird und sodann während einer zweiten Durchstimmsequenz zur Umschaltung der ersten Auswerteschaltung (LI) in ihren schmalbandigen Betriebsmodus und zur Umschaltung des ersten oder zweiten Wobbelgenerators auf die niedrigere Wobbelgeschwindigkeit herangezogen wird.

5. Verfahren nach einem der Ansprüche 1 bis 4, **dadurch gekennzeichnet,** daß die sekundären elektrischen Signale von Sekundärkorpuskeln gebildet werden, die durch den Primärstrahl in dem jeweils abgetasteten Punkt ausgelöst werden.

6. Verfahren nach einem der Ansprüche 1 bis 5, **dadurch gekennzeichnet,** daß eine Gruppe von Punkten auf der Probe von dem Primärstrahl nacheinander abgetastet wird, daß die Abtastgeschwindigkeit mittels eines Rastergenerators (RG) und einer von diesem angsteuerten Ablenkeinrichtung bestimmt wird und daß insbesondere eine Umschaltung des Rastergenerators (RG) auf eine reduzierte Abtastgeschwindigkeit in Abhängigkeit von dem Ausgangssignal der ersten oder zweiten Anwerteschaltung (LI') vorgenommen wird.

7. Anordnung zur Durchführung des Verfahrens nach einem der Ansprüche 1, 2, 5 oder 5 mit dem Rastermikroskop, dem ersten Wobbelgenerator (WG) und der ersten Auswerteschaltung (LI), **dadurch gekennzeichnet,** daß die erste Auswerteschaltung (LI) schmalbandig ausgebildet ist, daß eine entsprechend der ersten, jedoch wesentlich breitbandiger als diese ausgebildete, zweite Auswerteschaltung (LI') der ersten parallel geschaltet ist und daß das Ausgangssignal der zweiten Auswerteschaltung (LI') gegebenenfalls über einen Zwischenspeicher, insbesondere einen Rechner, dem Steuereingang eines den ersten oder zweiten Wobbelgenerator frequenzmäßig ansteuernden Generators (SG) zur Umschaltung auf eine niedrigere Wobbelgeschwindigkeit zuführbar ist.

8. Anordnung zur Durchführung des Verfahrens nach einem der Ansprüche 3 bis 6 mit dem Rastermikroskop, dem ersten Wobbelgenerator (WG) und der ersten Auswerteschaltung (LI), **dadurch gekennzeichnet,** daß diese in ihrer Bandbreite veränderbar ist und daß der Ausgang der ersten Auswerteschaltung (LI), gegebenenfalls über einen Zwischenspeicher, insbesondere einen Rechner, mit einem Steuereingang zur Umschaltung ihrer Bandbreite sowie mit dem Steuereingang eines den ersten oder zweiten Wobbelgenerator (WG) frequenzmäßig ansteuernden Generator - (SG) zur Umschaltung der Wobbelgeschwindigkeit verbunden ist.

9. Anordnung nach Anspruch 7 oder 8, **dadurch gekennzeichnet,** daß wenigstens eine der Auswerteschaltungen aus einem Lock-in-Verstärker (LI) besteht, der auf die Frequenz eines ihm zugeführten Referenzsignals abgestimmt wird.

10. Anordnung nach Anspruch 7 oder 8, **dadurch gekennzeichnet,** daß wenigstens eine der Auswerteschaltungen aus einem insbesondere abstimmbaren Bandpaß (13) und einem nachgeschalteten Demodulator, insbesondere Amplitudendemodulator (14) besteht.

11. Anordnung nach einem der Ansprüche 7 bis 10, **dadurch gekennzeichnet ,** daß der ersten Auswerteschaltung (LI) eine erste Schwellwertschaltung mit einem ersten Komparator (CM1) und einer diesem zugeführten ersten Vergleichsspannung nachgeschaltet ist.

12. Anordnung nach einem der Ansprüche 8 bis 10, **dadurch gekennzeichnet ,** daß der zweiten Auswerteschaltung (LI') eine zweite Schwellwertschaltung mit einem zweiten Komparator (CM2) und einer diesem zugeführten, zweiten Vergleichsspannung nachgeschaltet ist.

13. Anordnung nach einem der Ansprüche 7 bis 12, **dadurch gekennzeichnet ,** daß ein den jeweiligen Ort des abgetasteten Punktes definierendes, vom Rastergenerator - (RG) geliefertes Positionssignal zusammen mit dem Ausgangssignal der ersten Auswerteschaltung (LI) einer Aufzeichnungseinrichtung, insbesondere einem Rechner, zugeführt wird.

14. Anordnung nach einem der Ansprüche 7 bis 13, **dadurch gekennzeichnet,** daß der Generator (SG) mit der einen Ablenkeinrichtung für den Elektronenstrahl einer Bildröhre (CRT) beschaltet ist, deren Intensitätssteuereingang (5) mit dem Ausgang der ersten Auswerteschaltung (LI) verbunden ist, und daß insbesondere der Rastergenerator (RG) mit der anderen Ablenkeinrichtung der Bildröhre (CRT) beschaltet ist.

15. Anordnung nach einem der Ansprüche 7 bis 14, **dadurch gekennzeichnet** , daß der Ausgang der ersten oder zweiten Auswerteschaltung (LI, LI') mit einem Steuereingang (22) des Generators (SG) für eine zeitlich begrenzte Umkehrung der Wobbelrichtung und ein sich anschließendes Rückschalten in die ursprüngliche Wobbelrichtung verbunden ist, wobei zusammen mit diesem Rückschalten die Umschaltung auf die niedrigere Wobbelgeschwindigkeit erfolgt.

16. Anordnung nach einem der Ansprüche 7 bis 15, **dadurch gekennzeichnet**, daß das Ausgangssignal der zweiten Auswerteschaltung (LI') einem Steuereingang des Rastergenerators (RG) zum Zwecke einer Reduzierung der Rastergeschwindigkeit zugeführt wird.

FIG 1

# FIG 2

0 196 534

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IBM TECHNICAL DISCLOSURE BULLETIN, Band 12, Nr. 12, Mai 1970, Seite 2229, New York, US; D.P. GAFFNEY: "Detection of small potential differences in a scanning electron microscope" * Insgesamt * | 3 | G 01 R  31/28 |
| A | IDEM | 5,9 | |
| Y | DE-B-2 553 705  (SIEMENS AG) * Spalte 3, Zeilen 33-68; Spalte 4, Zeilen 13-44; Abbildungen 1-4 * | 3 | |
| A | | 1,2,4, 8,11- 13,15 | **RECHERCHIERTE SACHGEBIETE (Int. Cl.4)** |
| A | US-A-4 420 686  (ONOGUCHI et al.) * Abbildungen 1,2; Anspruch 5 * | 14 | G 01 R H 01 J |
| A | DE-A-1 943 140  (CAMBRIDGE SCIENTIFIC INSTRUMENTS LTD.) | | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 17-06-1986 | KAUFFMANN J. |

Europäisches
Patentamt

**EUROPÄISCHER RECHERCHENBERICHT**

Nummer der Anmeldung

EP 86 10 3572

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE TRANSACTIONS ON ELECTRON DEVICES, Band ED-26, Nr. 4, April 1979, Seiten 549-559, IEEE, New York, US; E. WOLFGANG et al.: "Electron-beam testing of VLSI circuits"  ----- | | |

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 17-06-1986 | Prüfer KAUFFMANN J. |
|---|---|---|